# EUROPEAN PATENT SPECIFICATION

(11) **EP 0 986 655 B1**
(45) Date of publication and mention of the grant of the patent: **19.12.2001**
(21) Application number: 98923236.8
(22) Date of filing: 03.06.1998
(51) Int. Cl.: C30B 9/00, C30B 29/40, C30B 11/00

(54) **THE METHOD OF FABRICATION OF HIGHLY RESISTIVE GaN BULK CRYSTALS**
VERFAHREN ZUR HERSTELLUNG VON GaN KRISTALLEN MIT HOHEM WIDERSTAND
PROCEDE DE FABRICATION DE CRISTAUX DE GaN MASSIFS ET HAUTEMENT RESISTIFS

(30) Priority: 05.06.1997 PL 32039297
(43) Date of publication of application: 22.03.2000
(73) Proprietor: Centrum Badan Wysokocisnieniowych Polskiej Akademii Nauk, 01 142 Warszawa (PL)
(72) Inventor: LUCZNIK, Boleslaw, PL-01-651 Warszawa (PL); SUSKI, Tadeusz, PL-02-786 Warszawa (PL); WROBLEWSKI, Miroslaw, PL-01-011 Warszawa (PL); POROWSKI, Sylwester, PL-01-572 Warszawa (PL); BOCKOWSKI, Michal, PL-01-168 Warszawa (PL); GRZEGORY, Izabella, PL-01-886 Warszawa (PL); KRUKOWSKI, Stanislaw, PL-02-400 Warszawa (PL); LESZCZYNSKI, Michal, PL-02-791 Warszawa (PL)
(74) Representative: Woodward, John Calvin
(86) International application number: PCT/PL98/00023
(87) International publication number: WO 98/55671

(56) References cited:
- WO-A-95/04845
- WO-A-97/13891
- FR-A- 2 313 976
- PATENT ABSTRACTS OF JAPAN vol. 98, no. 5 & JP 10 007496 A (HITACHI CABLE LTD )
- POROWSKI ET AL: "Thermodynamical properties of III-V nitrides and crystal growth of GaN at high N2 pressure" JOURNAL OF CRYSTAL GROWTH., vol. 178, 2 June 1997, pages 174-188, XP004084984 AMSTERDAM NL
- KARPINSKI ET AL: "Equilibrium pressure of N2 over GaN and high pressure solution growth of GaN" JOURNAL OF CRYSTAL GROWTH., vol. 66, 1984, pages 1-10, XP002079608 AMSTERDAM NL
- YAMANE ET AL: "Preparation of GaN single crystals using a Na flux" CHEMISTRY OF MATERIALS, vol. 9, February 1997, pages 413-416, XP000686510 WASHINGTON US

## Description

This invention relates to the method of fabrication of. highly resistive GaN bulk crystals for the manufacturing of optoelectronic devices.

In the known method the highly resistive GaN bulk crystals are obtained by crystallisation from the solution of atomic nitrogen in the molten mixture of metals, containing gallium in the concentration not lower than 90 at.% and the Periodic Table group II metals: magnesium, calcium, zinc, beryllium or cadmium in the concentration of 0.01-10 at.%. The process is conducted under the nitrogen pressure 0.5-2.0 GPa, at the temperature 1300 - 1700°C and in the presence of temperature gradient.
Example of the process for growing GaN crystals is disclosed in publication WO 95/04845, where in first step a crucible containing gallium melt was pressurised with 1 GPa of nitrogen gas. A temperature gradient (between parts at 1410°C and 1350°C). was then established in the crucible and GaN crystals were obtained. In a second step the pressure was decreased by 1 kbar and a layer of low N vacancy GaN was grown on the original crystals. In order to dope the final crystal about 10 at.% of impurities (magnesium) was added to the melt.

According to the invention GaN crystallisation is conducted in the temperature gradient not higher than 10°C/cm.
Such gradient assures low supersaturation in the growth zone, necessary to obtain GaN crystal growth velocity lower than 0.2 mm/h, necessary for stable growth of large size crystals.

In the result of the growth process hexagonal GaN plate-like crystals are obtained, having the specific resistivity 10⁴-10⁸ Ωcm, characterised by high structural quality and the lattice parameters close to the perfect crystal. These so obtained crystals are not available by the other methods and can be used as perfect substrates for unstrained homoepitaxial GaN layers.

The subject of the invention is demonstrated on the following example.

### Example

The molten mixture of semiconductor purity metals consisting of 99.5 at.% of gallium and 0.5 at.% of magnesium is poured into the vertically configured graphite crucible under the shield of inert gas. The crucible is located into the three-zone graphite furnace which in turn is positioned inside the highpressure vessel, which in the first stage is evacuated to the vacuum level of 10⁻⁵ Torr. The system is annealed in the vacuum at the temperature 800°C during 12 hours. After the annealing, the vessel is filled with nitrogen of 6N purity achieving the initial pressure of 10-15 MPa. Then the gas is compressed to the pressure of 1.5 GPa and after the compression, the crucible is heated to the temperature of 1550°C in such way that the temperature along the crucible axis is kept constant. Then the temperature of the lower end of the crucible is lowered by 30°C obtaining the temperature gradient along the axis of the crucible. These conditions of the process are preserved during the period of 120 hours. After 120 hours of crystallisation, the system is cooled down with the rate of 5°C/min to the room temperature and after that the nitrogen pressure is lowered to the atmospheric pressure. After the extraction of the crucible from the high pressure vessel, the crucible is warmed up to the temperature 50°C and the molten metal is poured out from the crucible. At the bottom of the crucible there are GaN crystals in the form of hexagonal plates of the size of 6 - 8 mm. The GaN crystals are extracted from the crucible and etched in aqua regia in order to remove the remaining parts of metal.

GaN crystals, obtained in this process characterise by specific resistivity equal to 10⁶ Ωcm and high structural quality. The halfwidth of (0004) reflection of x-ray αCuK line is 20-30 arc sec, and the **a** and **c** lattice parameters are very uniform and are equal to: 3.1877Å and 5.1848Å, respectively.

## Claims

1. The method of fabrication of highly resistive GaN bulk crystals by crystallisation from the solution of atomic nitrogen in the molten mixture of metals, containing gallium in the concentration not lower than 90 at.% and the Periodic Table group II metals: magnesium, calcium, zinc, beryllium or cadmium in the concentration of 0.01-10 at.%, at the temperature 1300 - 1700°C, under the nitrogen pressure 0.5-2.0 GPa and in the presence of temperature gradient **characterised by** the temperature gradient not higher than 10°C/cm.

## Patentansprüche

1. Verfahren zur Herstellung von GaN-Massenkristallen mit hohem Widerstand durch Kristallisation aus der Lösung von atomarem Stickstoff in der geschmolzenen Mischung von Metallen, die Gallium in der Konzentration nicht unter 90 Atom-% und die Metalle der Gruppe II des Periodensystems: Magnesium, Calcium, Zink, Beryllium oder Cadmium in der Konzentration von 0,01 bis 10 Atom% enthält, bei der Temperatur von 1300 bis 1700 °C unter dem Stickstoffdruck von 0,5 bis 2,0 GPa und in Gegenwart eines Temperaturgradienten, der durch den Temperaturgradienten nicht höher als 10 °C/cm **gekennzeichnet** ist.

## Revendications

1. La méthode de fabrication de cristaux massifs de GaN à résistivité élevée par cristallisation, en solution dans l'azote atomique, d'un mélange en fusion de métaux contenant du gallium à une concentration non inférieure à 90 at.% et des métaux du Groupe II du Tableau Périodique : magnésium, calcium, zinc, beryllium ou cadmium, à une concentration de 0,01-10 at.% à une température de 1300-1700°C, sous une pression d'azote de 0,5-2,0 GPa et en présence d'un gradient de température, **caractérisée par le fait que** le gradient de température n'est pas supérieur à 10°C/cm.
